Europäisches Patentamt

European Patent Office

Office européen des brevets

(11) Veröffentlichungsnummer : **0 084 191**
**B1**

(12) **EUROPÄISCHE PATENTSCHRIFT**

(45) Veröffentlichungstag der Patentschrift :
07.05.86

(51) Int. Cl.⁴ : **G 01 R 31/08, H 02 H 3/38**

(21) Anmeldenummer : **82201504.6**

(22) Anmeldetag : **26.11.82**

(54) **Verfahren zum Nachweis einer Störung längs eines Leiters in einem Verbundnetz.**

(30) Priorität : **15.01.82 CH 230/82**

(43) Veröffentlichungstag der Anmeldung :
**27.07.83 Patentblatt 83/30**

(45) Bekanntmachung des Hinweises auf die Patenterteilung : **07.05.86 Patentblatt 86/19**

(84) Benannte Vertragsstaaten :
**CH DE GB LI NL SE**

(56) Entgegenhaltungen :
**EP-A- 0 035 365**
**FR-A- 2 309 877**
**FR-A- 2 435 143**
**US-A- 3 379 934**
**US-A- 4 212 046**
**VDE - FACHBERICHTE, Band 26, 1970, Seiten 21-26,**
**W. HALAMA: "Elektronischer Distanzschutz"**

(73) Patentinhaber : **BBC Aktiengesellschaft Brown,
Boveri & Cie.**
**Haselstrasse**
**CH-5401 Baden (CH)**

(72) Erfinder : **Lanz, Otto**
**Zweierestrasse 5d**
**CH-5443 Niederrohrdorf (CH)**

## Beschreibung

Die vorliegende Erfindung betrifft ein Verfahren zum Nachweis einer Störung längs eines Leiters in einem Verbundnetz zum Verteilen elektrischer Energie, wobei aus Eingangssignalen, die den durch eine Störung oder Laständerung bewirkten sprunghaften Aenderungen von Strom bzw. Spannung entsprechen, Sprungsignale gebildet und zu einem Kombinationssignal verknüpft werden, welches Kombinationssignal zur Unterscheidung einer Störung und einer zulässigen Laständerung, sowie zum Bestimmen der Richtung der Störung relativ zum Nachweisort mit einem vorgegebenen Grenzwert verglichen wird, sowie eine Vorrichtung zur Ausführung dieses Verfahrens.

Die Verteilung der von einem oder mehreren Kraftwerken erzeugten Energie an die Verbraucher erfolgt über Verbundnetze, die auch bei stark schwankendem Verbrauch eine gleichmässige Versorgung und eine möglichst gleichmässige Belastung der Kraftwerke ermöglichen sollen. Die Verbundnetze sind in voneinander trennbare Sektionen unterteilt, um zu vermeiden, dass bei einer Störung, beispielsweise einem Kurzschluss der Leitung das gesamte Verbundnetz beeinträchtigt wird. Jeder Sektion ist eine Ueberwachungsvorrichtung zugeordnet, die beim Nachweis einer Störung ein Fehlersignal erzeugt, das das Abtrennen der gestörten Sektion vom Verbundnetz bewirkt.

Für die Ueberwachung einer Leitung auf mögliche Störungen werden der zeitliche Ablauf von Strom und Spannung beobachtet, wobei die Ueberwachungsvorrichtung aus praktischen Gründen gewöhnlich im Bereich eines Verbindungspunkts des Netzes angeordnet ist. Für die Auswertung sprunghafter Aenderungen des Stroms- und Spannungsverlaufs gilt : (a) wenn der Stromfluss zusammenbricht oder sprunghaft ansteigt, liegt der Ort der Störung oder Laständerung zwischen der Stromquelle und der Ueberwachungsstation bzw. zwischen der Ueberwachungsstation und den Verbrauchern, (b) der Betrag der Strom- und der Spannungsänderung ermöglicht das Unterscheiden zwischen einer zulässigen Laständerung und einer unzulässigen Störung und (c) die Spannung bricht im Bereich der Ueberwachungsstation immer zusammen, unabhängig davon ob der Ort der Störung zwischen der Ueberwachungsstation und der Stromquelle oder den Verbrauchern, d. h. in der Stromflussrichtung vor oder nach der Ueberwachungsstation liegt.

Die Verwertung dieser Regeln hat zu Ueberwachungsvorrichtungen geführt, bei denen die sprunghafte Aenderung sowohl des Stroms, als auch der Spannung mit einem vorgegebenen festen Grenzwert verglichen und beim Ueberschreiten des Grenzwerts ein Fehlersignal ausgelöst wird und bei denen weiter das Vorzeichen der Strom- und der Spannungsänderung miteinander verglichen werden und daraus die Richtung des Fehlers relativ zur Ueberwachungsstation bestimmt wird.

Wie jedem Fachmann bekannt ist, werden die sprunghaften Aenderungen von Strom und Spannung bei einer Störung oder einem Lastwechsel und deren Weiterleitung in Form einer Wanderwelle vom Phasenwinkel der Spannung zum Zeitpunkt der Störung oder des Lastwechsels sowie von der Impedanz der Leitung und insbesondere der Stromquelle beeinflusst. Die vorstehend beschriebene Ueberwachungseinrichtungen weisen darum eine relativ starke Abhängigkeit der Auslöseempfindlichkeit nicht nur vom Phasenwinkel der Spannung zum Zeitpunkt der Störung oder Laständerung, sondern insbesondere auch von der Quellenimpedanz auf.

Um diese Mängel zu beheben, wird in der DE-B2 28 41 009 (entspricht FR-A-2 435 143) ein Verfahren angegeben, bei dem Sprungsignale ausgewertet werden, die der Differenz zwischen dem « normalen » und dem durch eine Störung oder Laständerung bewirkten, veränderten zeitlichen Verlauf von Strom und Spannung entsprechen, wobei wahlweise entweder eines der beiden Sprungsignale mit einem Grenzwert verglichen wird, der nach einer vorgegebenen Funktion aus dem anderen Sprungsignal gebildet ist, oder aus dem Strom- und dem Spannungs-Sprungsignal nach einer vorgegebenen Verknüpfungsregel ein Kombinationssignal gebildet und mit einem festen Grenzwert verglichen wird. In einem rechtwinkligen Koordinatensystem, dessen Achsen dem Strom- bzw. dem Spannungs-Sprungsignal zugeordnet sind, werden als Auslösegrenzen vorzugsweise solche Grenzwerte verwendet, die gegenüber den Koordinatenachsen geneigt sind, und deren Verlauf und Lage entsprechend den praktisch zu überwachenden Netz- und Leitungskonfigurationen und insbesondere den Impedanzen der Stromquelle und der Leitung angepasst werden können. Damit können die Abhängigkeit der Auslöseempfindlichkeit von der Quellenimpedanz ganz wesentlich verringert und die Sicherheit gegen Fehlauslösungen entsprechend erhöht werden.

Der zeitliche Verlauf des gemäss der genannten Auslegeschrift durch eine rationale Funktion und vorzugsweise eine Linearkombination der Sprungsignale gebildeten Kombinationssignals entspricht in dem erwähnten Koordinatensystem, insbesondere wegen der Phasenverschiebung zwischen Strom und Spannung einer ellipsenähnlich gekrümmten Bahn (nachfolgend auch Trajektorie genannt), die in Abhängigkeit vom Phasenwinkel der Spannung zum Zeitpunkt der Störung oder des Lastwechsels längs der dem Stromsprungsignal zugeordneten Koordinatenachse verschoben ist. Damit besteht die Möglichkeit, dass das (gekrümmte) Kombinationssignal bei entsprechenden Randbedingungen den (gegenüber den Koordinatenachsen geneigten) Grenzwert nicht klar schneidet, sonderen sich diesem schleifend nähert, was eine fehlerhafte Auslösung oder Unterdrükkung oder zeitlicher Verzögerung eines Fehlsignals oder eine falsche Richtungsanzeige bewirken kann. Die Möglichkeit der Auslösung eines unberechtigten Fehlersignals wird noch erhöht, weil die aus einem Gemisch zeitlich veränderlicher Signale ausgefilterte Trajektorie nur angenähert ellipsen- oder kreisbogenförmig ist, weil das Stromsprungsignal, wenn es nicht im Bereich des Maximums der Periode der Netzspannung entsteht, einen exponentiell abklingenden Gleichstromanteil enthält, der die Trajektorie verzerrt und weil der Verlauf der Trajektorie schliesslich auch von der Impedanz der Stromquelle abhängig ist.

Der vorliegenden Erfindung lag daher die Aufgabe zugrunde, das in der oben genannten Auslegeschrift beschriebene Verfahren zu verbessern und dessen aufgezeigte Mängel zu beheben.

Erfindungsgemäss wird diese Aufgabe mit einem Verfahren der eingangs genannten Art gelöst, bei dem durch Verschieben des zeitlichen Verlaufs mindestens eines der Eingangssignale oder mindestens eines der Sprungsignale selbst die Phasenverschiebung zwischen den beiden Sprungsignalen vor ihrer Ueberlagerung zum Kombinationssignal praktisch aufgehoben wird, so dass der zeitliche Verlauf des Kombinationssignals in einem rechtwinkligen Koordinatensystem, dessen Achsen den beiden Sprungsignalen zugeordnet sind, praktisch einer Geraden entspricht.

Mit dem neuen Verfahren kann die schleifende Näherung des Kombinationssignals an einen vorgegebenen Grenzwert vermieden, und damit eine durch diese Art der Näherung bewirkte fehlerhafte Auslösung oder Unterdrückung oder zeitliche Verzögerung eines Fehlersignals vermieden werden.

Bei einer bevorzugten Ausführungsform des neuen Verfahrens wird das dem Spannungs-Sprungsignal nachlaufende Strom-Sprungsignal durch Wandlung in ein abhängiges Spannungs-Sprungsignal vorverschoben und dadurch erreicht, dass ein eventuelles Fehlersignal in der kürzestmöglichen Zeitspanne ausgelöst wird.

Bei einer weiteren bevorzugten Ausführungsform des neuen Verfahrens wird zur Wandlung des Strom-Sprungsignals in ein vorgeschobenes, abhängiges Spannungs-Sprungsignal eine Nachbildung der Impedanz der Stromquelle verwendet. Damit kann der exponentiell abklingende Gleichstromanteil des Strom-Sprungsignals, der im allgemeinen auftritt, wenn der Zeitpunkt der Störung oder Laständerung nicht mit dem des Maximums der Wechselspannung auf der Leitung übereinstimmt und der Einfluss dieses Gleichstromanteils auf das Kombinationssignal bzw. die Trajektorie aufgehoben werden.

Nachfolgend wird das erfindungsgemässe Verfahren mit Hilfe der Figuren und zweier bevorzugten Ausführungsformen von Vorrichtungen zur Ausführung dieses Verfahrens beschrieben. Es zeigen :

Figur 1 eine graphische Darstellung des zeitlichen Verlaufs von Kombinationssignalen gemäss dem Stand der Technik

Figur 2 eine graphische Darstellung mit dem zeitlichen Verlauf von Kombinationssignalen gemäss der vorliegenden Erfindung und

Figur 3 und 4 das Blockschema einer ersten bzw. einer zweiten Ausführungsform einer Vorrichtung zur Ausführung des erfindungsgemässen Verfahrens.

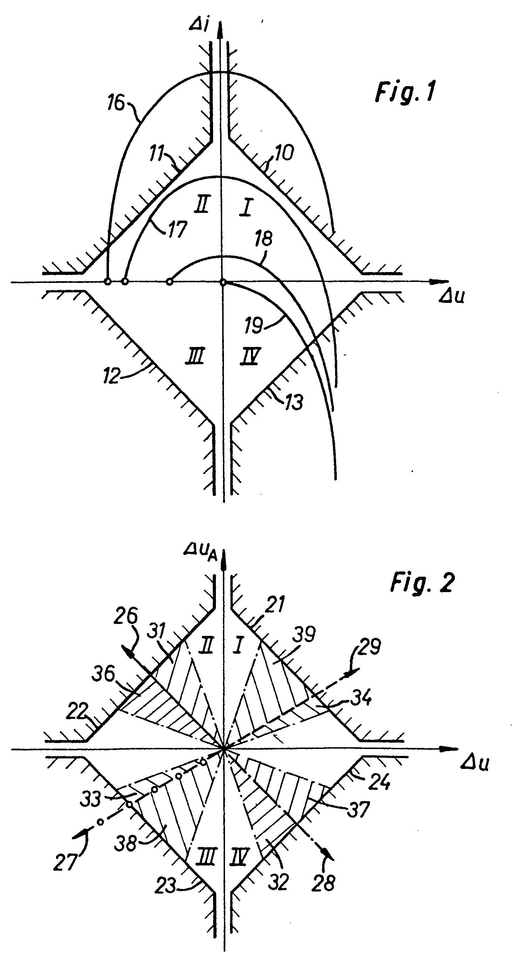

Zum besseren Verständnis der mit der vorliegenden Erfindung erreichbaren Vorteile ist in Fig. 1 das aus der einleitend genannten deutschen Ausleschrift bekannte rechtwinklige Koordinatensystem gezeigt, dessen Abszisse den Spannungs-Sprungsignalen $\Delta U$ und dessen Ordinate den Strom-Sprungsignalen $\Delta I$ zugeordnet ist. In jeden Quadrant des Koordinatensystems ist ein vorgegebener Grenzwert 10, 11, 12 bzw. 13 eingezeichnet. Weiter sind Trajektorien 16, 17, 18 und 19 gezeigt, die dem zeitlichen Verlauf von Kombinationssignalen entsprechen, deren zugeordnetes Spannungs-Sprungsignal im Maximum, 30° bzw. 60° nach diesem Maximum und beim Nulldurchgang der Netzspannung erscheint.

Wie die Figur 1 zeigt, bilden die Trajektorien ellipsenförmige Bahnen, deren Anfangspunkt auf der $\Delta U$-Achse liegt und in Abhängigkeit vom Phasenwinkel der Netzspannung, bei dem das Spannungs-Sprungsignal erzeugt wird, aus dem Koordinatenanfangspunkt verschoben ist. Die entsprechende Verschiebung des Ellipsenmittelpunkts auf der $\Delta I$-Achse hat zur Folge, dass im gewählten Beispiel die Trajektorie 19, deren Anfangspunkt im Koordinatenanfangspunkt liegt bzw. am weitesten daraus verschoben ist, den nächstliegenden Grenzwert 13 im IV. Quadranten schneidet und ein gesichertes Fehlersignal auslöst, während die beiden Trajektorien 18 und 17, deren Anfangspunkte zwischen den Trajektorien 16 und 19 liegen, im II. und I. Quadranten innerhalb der von den Grenzwerten 11 bzw. 10 eingeschlossene Fläche verlaufen und erst im IV. Quadranten den Grenzwert 13 schneiden. Das bedeutet nicht nur, dass die entsprechenden Fehlersignale zeitlich verzögert ausgelöst werden, sondern dass die schleifende Näherung beispielsweise der Trajektorie 17 an den Grenzwert 10 ein Fehlersignal mit falscher Richtungsanzeige auslösen kann. Die Möglichkeit der Auslösung eines unberechtigten Fehlersignals oder der Anzeige einer falschen Fehlerrichtung ist umso grösser, weil, wie bereits einleitend beschrieben wurde, die Bahn der Trajektorie in der Praxis gegenübe den in der Figur gezeigten simulierten Bahnen stark verzerrt sein kann.

Die Fig. 2 zeigt ein rechtwinkliges Koordinatensystem, dessen Abszisse den Spannungs-Sprungsignalen $\Delta U$ und dessen Ordinate den von den Strom-Sprungsignalen abgeleiteten und mit den Spannungs-Sprungsignalen praktisch gleichphasigen Abbildspannungs-Sprungsignalen $\Delta U_a$ zugeordnet ist. In die vier Quadranten des Koordinatensystems sind Grenzwerte 21, 22, 23 bzw. 24 eingezeichnet. Wegen der praktischen Phasengleichheit der Sprungsignale der Spannung und der Abbildspannung liegt der Anfangspunkt der Trajektorie in Abhängigkeit vom Phasenwinkel der Netzspannung zum Zeitpunkt der Störung oder Laständerung auf der entsprechenden Trajektorie. Aus dem gleichen Grunde sind die dem zeitlichen Verlauf der Kombinationssignale entsprechenden Trajektorien nicht mehr kreisbogen- oder ellipsenförmig, sondern praktisch zu Geraden entartet. Diese Geraden verlaufen unabhängig vom Phasenwinkel der Netzspannung, bei der ein Spannungs-Sprungsignal erzeugt wird, durch den Koordinatenanfangspunkt und werden von einem Gleichstromanteil im Strom-Sprungsignal (der bei der Verwendung einer der Quelle entsprechenden Abbildimpedanz weitgehend unterdrückt wird) nicht und von der Qualität der Filterung des ursprünglichen Eingangssignals nur wenig beeinflusst. Nur der Winkel der Trajektorie zu den Koordinatenachsen ändert sich in Abhängigkeit vom Verhältnis der Stromquelle zur Impedanz der Abbildung. Die gezeigten Trajektorien 26, 27 entsprechen einer Störung in der Vorwärts- bzw. in der Rückwärtsrichtung und während der positiven Halbwelle der Netzspannung, die Trajektorien 28 und 29 entsprechen einer Störung in der Vorwärts- bzw. Rückwärtsrichtung während der negativen Halbwelle der Netzspannung. Die gezeigte Richtung der Trajektorien (45° zu den Koordinatenachsen) entspricht (bei einem entsprechend gewählten Massstab der Koordinaten) einem Verhältnis der Impedanz der Stromquelle zur Impedanz der Abbildung wie 1:1. Ist die Impedanz der Stromquelle kleiner als die der Abbildung, dann wird die Trajektorie in den benachbarten gestrichelten Bereich 31, 32, 38 bzw. 39 und ist die Impedanz der Stromquelle grösser als die der Abbildung, dann wird die Trajektorie in den benachbarten Bereich 36, 37, 33 bzw. 34 verschwenkt.

Die Konstruktion der Trajektorie aus den Sprungsignalen ist jedem Fachmann möglich, weshalb auf deren Herleitung verzichtet wird.

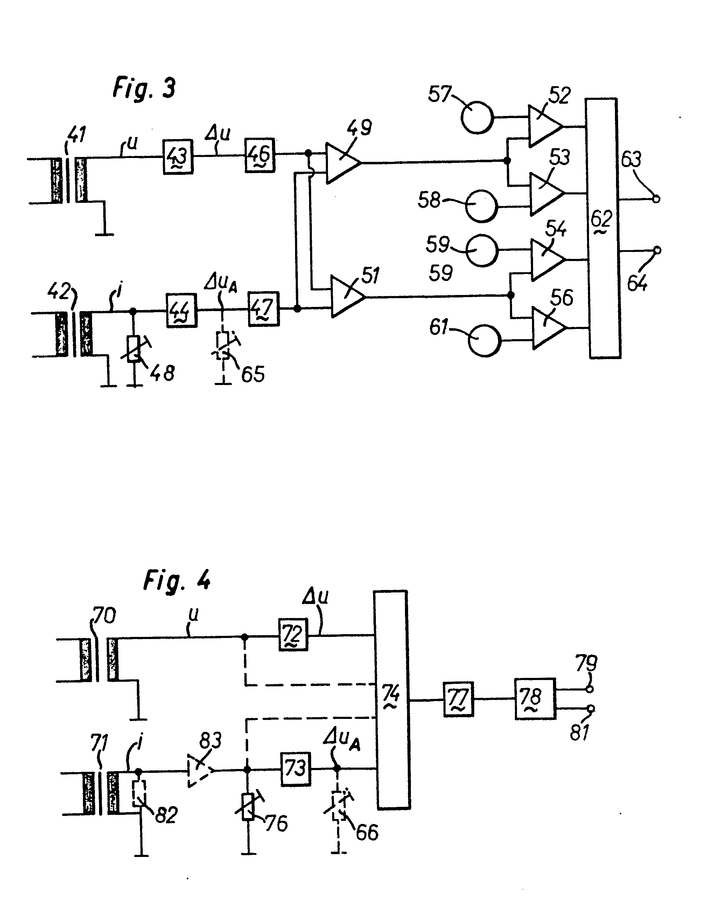

Die Fig. 3 zeigt das Blockschaltbild einer ersten Ausführungsform einer Vorrichtung zum Ausführen des erfindungsgemässen Verfahrens. Die Vorrichtung enthält zwei Eingangswandler 41, 42 die primärseitig direkt oder über geeignete (nicht gezeigte) Messwandler an das zu überwachende Leitungsnetz angeschlossen sind. Der Signalausgang jedes Eingangswandlers ist über ein Bandsperrfilter 43 bzw. 44 mit dem Eingang eines zugeordneten Verstärkers 46 bzw. 47 verbunden. An die Verbindungsleitung vom Signalausgang des einen Eingangswandlers 42 zum nachgestellten Bandsperrfilter 44 ist ausserdem eine Abbildschaltung 48 angeschlossen. Die Ausgänge der beiden Verstärker 46, 47 sind mit den zum Addieren von Eingangssignalen versehenen Eingänge eines ersten Rechenverstärkers 49 und mit dem zum Subtrahieren von Eingangssignalen vorgesehenen Eingängen eines zweiten Rechenverstärkers 51 verbunden. Die Vorrichtung enthält weiter zwei Paare Komparatoren 52, 53 und 54, 56, wobei der invertierende und der nichtinvertierende Eingang je eines der Komparatoren jedes Paars mit dem Ausgang eines der Rechenverstärker und der dazugehörige nichtinvertierende bzw. invertierende Eingang mit einem Grenzwertgeber 57, 58 bzw. 59, 61 verbunden ist. Die Ausgänge aller Komparatoren sind mit zugeordneten Eingängen einer Schaltlogik 62 verbunden, die zwei Ausgänge aufweist, welcher an die Ausgangssignalklemmen 63, 64 angeschlossen sind.

Zur Beschreibung der Arbeitsweise dieser Vorrichtung sei angenommen, dass die Spannung auf der zu überwachenden Leitung zusammenbricht und der Strom eine sprunghafte Aenderung erfährt. Dann erscheint am Signalausgang des der Spannung zugeordneten Eingangswandlers 41 ein entsprechendes Eingangssignal U und am Signalausgang des dem Strom zugeordneten Eingangswandlers 42 ein dem Spannungs-Eingangssignal nachlaufendes Strom-Eingangssignal I. Das Strom-Eingangssignal I wird am Anschlusspunkt der Abbildschaltung 48 in ein Abbildspannungssignal $U_a$ gewandelt, bei dem mindestens der netzfrequente Anteil gegenüber dem Strom-Eingangssignal I phasenverschoben und etwa phasengleich mit dem Spannungs-Eingangssignal U ist, wenn der Impedanzwinkel der Abbildschaltung 48 dem Impedanzwinkel der Stromquelle entspricht. Die Bandsperrfilter 43, 44 halten das der Netzfrequenz bei ungestörter Leitung entsprechende Eingangssignal zurück, sodass in ihrem Ausgang nur bei einer Störung oder Laständerung Sprungsignale erscheinen. Das Spannungs-Sprungsignal $\Delta U$ und das Abbildspannungs-Sprungsignal $\Delta U_a$ werden dann in dem zugeordneten Verstärker 46 bzw. 47 auf vergleichbare Werte verstärkt. Die verstärkten Sprungsignale werden danach in dem einen Rechenverstärker 49 addiert und in dem anderen Rechenverstärker 51 subtrahiert. Entsprechend den in der Einleitung beschriebenen Regeln erscheint dann ein Ausgangssignal am Addierverstärker 49, wenn die Ursache für die Sprungsignale in der Stromflussrichtung gesehen hinter der Vorrichtung liegt bzw. am Ausgang des Subtrahierverstärkers 51, wenn diese Ursache vor der Vorrichtung liegt (was einer Lage der in Fig. 2 gezeigten Trajektorien im I. oder III. bzw. im II. oder IV. Quadranten des Koordinatensystems entspricht). Das Ausgangssignal des Rechenverstärkers 49 oder 50 wird dann in den Komparatoren 52, 53 bzw. 54, 56 mit einem positiven und einem negativen, von einem einstellbaren Grenzwertgeber 57, 58 bzw. 59, 61 zugeleiteten Grenzwert verglichen, welche Grenzwerte den in Fig. 2 gezeigten Werten 23, 21 bzw. 22, 24 entsprechen. Ist das in einem der Rechenverstärker 49, 51 gebildete Kombinationssignal grösser als der entsprechende Grenzwert, dann erscheint am zugeordneten Komparator ein Ausgangssignal, das in der Logikschaltung 62 verarbeitet wird und ein Fehlersignal erzeugt, das in Abhängigkeit von der Richtung des Fehlers relativ zur Vorrichtung an einer der Ausgangsklemmen 63 oder 64 abgenommen werden kann, um beispielsweise eine Leitungtrenneinrichtung auszulösen.

In Fig. 4 ist das Blockschaltbild einer anderen Ausführungsform einer Vorrichtung zum Ausführen des erfindungsgemässen Verfahrens gezeigt. Diese Ausführungsform enthält ebenfalls zwei Eingangswandler 70, 71, die, wie bei der Ausführungsform gemäss der Fig. 3, direkt oder über einen nicht gezeigten Signalwandler an das zu überwachende Netz angeschlossen sind. Der Signalausgang jedes eingangswandlers ist über ein zugeordnetes Bandsperrfilter 72 bzw. 73 an einen Eingang eines Multiplexers 74 geführt. An die Verbindungsleitung vom Signalausgang des Eingangswandlers 71 für das Strom-Sprungsignal zum zugeordneten Bandsperrfilter 73 ist eine Abbildschaltung 76 angeschlossen, deren Impedanzwinkel demjenigen der Stromquelle entspricht. Dem Multiplexer ist ein A/D-Wandler 77 nachgeschaltet, dessen Ausgang mit dem Eingang eines Mikroprozessors 78 verbunden ist. Der Mikroprozessor 78 weist zwei Ausgänge auf, die mit Ausgangsklemmen 79, 81 verbunden sind, von denen die eine für Fehlersignale, die durch Störungen im Vorwärts- und die andere, für Fehlersignale, die durch Störungen in Rückwärtsrichtung bewirkt werden, vorgesehen ist.

Bei der Verwendung dieser Vorrichtung wird eine auf der zu überwachende Leitung erscheinende sprunghafte Spannungsänderung vom Eingangswandler 70 übertragen. Das nachgeschaltete Bandsperrfilter 72 hält das der Netzfrequenz bei ungestörter Leitung entsprechende Eingangssignal zurück, sodass an seinem Ausgang nur bei einer Störung oder Laständerung ein Spannungs-Sprungsignal $\Delta U$ erscheint, das an den Multiplexer weitergeleitet wird. Die auf der zu überwachenden Leitung erscheinende sprunghafte Stromänderung wird vom Eingangswandler 71 übertragen. Das Ausgangssignal des Eingangswandlers wird an die Abbildschaltung 76 geleitet, an deren anschlusspunkt dann eine dem Strom-Eingangssignal und dem Impedanzwinkel der Abbildschaltung 76 entsprechende Abbildspannung $U_a$ erscheint. Da die Abbildschaltung 76 die von der Impedanz der Stromquelle bewirkte Phasenverschiebung mindestens des netzfrequenten Anteils des Strom-Eingangs-gegen das Spannungs-Eingangssignal praktisch aufhebt, ist die Phasenlage dieser Abbildspannung $U_a$ auch praktisch gleich der Phasenlage des Spannungs-Signals U. An den Ausgängen der Bandsperrfilter 72, 73 erscheinen dann ein Spannungs- bzw. ein Abbildspannungs-Sprungsignal $\Delta U$ bzw. $\Delta U_a$. Die analogen Sprungsignale werden im Multiplexer 74 ineinander verschachtelt und im nachgeschalteten A/D-Wandler 77 in eine Folge digitaler Signale gewandelt. Die digitalen Signale werden dann im Mikroprozessor verarbeitet, wobei die Amplitude und die Vorzeichen der beiden Sprungsignale verglichen und damit die Richtung der Ursache für diese Sprungsignale relativ zur Vorrichtung bestimmt und die kombinierten Sprungsignale zum Unterscheiden einer Störung und einer zulässigen Laständerung mit vorgegebenen Grenzwerten verglichen werden. Gegebenenfalls wird dann ein Fehlersignal gebildet, das in Abhängigkeit von der Richtung der Störung an einer der beiden Ausgangsklemmen 79 oder 81 erscheint.

Es versteht sich, dass die Abbildschaltungen 48, 76 nicht notwendigerweise mit der Eingangsleitung zum Bandsperrfilter 44 bzw. 73, sondern ebensogut mit der Ausgangsleitung des zugeordneten Bandsperrfilters verbunden werden können, was in den Fig. 3 und 4 durch die mit gestrichelten Linien gezeichneten Abbildschaltungen 65 bzw. 66 gezeigt ist. Es versteht sich weiter, dass die zusätzliche Abbildschaltung durch einen als Streutransformator ausgebildeten Eingangswandler 42, 71, dessen Sekundärwirckung ein Widerstand parallel geschaltet ist, ersetzt werden kann.

Wenn die beschriebene Schaltung auch zum Schutz gegen Draufschaltfehler verwendet werden soll, kann es vorteilhaft sein, die beiden Enden der Sekundärwicklung des Eingangswandlers 71 mit einem Widerstand 82 zu verbinden und die Signalausgänge der beiden Eingangswandler 70, 71 direkt, d. h. unter Umgehung des nachgeschalteten Bandsperrfilters mit einem Eingang des Multiplexers zu verbinden. In die Leitung zwischen dem Signalausgang des dem Strom zugeordneten Eingangswandlers 71 und dem Verbindungspunkt mit der Abbildschaltung 86 wird dann vorteilhafterweise ein Impedanzwandler 83 geschaltet. Weiter ist es möglich, bei einer Ausführungsform mit einem Mikroprozessor auf die Bandpassfilter (72, 73 in Fig. 4) zu verzichten, und die Ausgänge der Eingangswandler direkt mit der Zeitmultiplexschaltung zu verbinden (was in Fig. 4 mit gestrichelten Linien gezeigt ist). Die Sprungsignale werden dann bei entsprechender Programmierung im Mikroprozessor gebildet.

Das neue Verfahren wurde einfacherweise mit Hilfe von Vorrichtungen zum Ueberwachen einphasiger Netze beschrieben. Wie jeder Fachmann sofort erkennt, können diese Schaltungen ohne erfinderisches Zutun zum Ueberwachen von mehrphasigen Netzen erweitert werden. Die Vorrichtungen können mit handelsüblichen Bauelementen aufgebaut werden, wobei es im Bereich fachmännischen Könnens liegt, die für einen gegebenen Zweck besser geeignete Einrichtung bzw. das bestgeeignete Bauelement auszuwählen und beispielsweise einen A/D-Wandler zu verwenden, dem eine Sample-and-Hold-Schaltung vorgesetzt ist.

**Patentansprüche**

1. Verfahren zum Nachweis einer Störung längs eines Leiters in einem Vebundnetz zum Verteilen elektrischer Energie, wobei aus Eingangssignalen, die den durch eine Störung oder Laständerung bewirkten sprunghaften Aenderungen von Strom bzw. Spannung entsprechen, Sprungsignale gebildet und zu einem Kombinationssignal verknüpft werden, welches Kombinationssignal zur Unterscheidung einer Störung und einer zulässigen Laständerung, sowie zum Bestimmen der Richtung der Störung relativ zum Nachweisort mit einem vorgegebenen Grenzwert verglichen wird, dadurch gekennzeichnet, dass durch Verschieben des zeitlichen Verlaufs mindestens eines der Eingangssignale oder mindestens eines der Sprungsignale selbst die Phasenverschiebung zwischen den beiden Sprungsignalen vor ihrer Ueberlagerung zum Kombinationssignal praktisch aufgehoben wird, so dass der zeitliche Verlauf des Kombinationssignals in einem rechtwinkligen Koordinatensystem, dessen Achsen den beiden Sprungsignalen zugeordnet sind, praktisch einer Geraden entspricht.

2. Verfahren nach Anspruch 1, dadurch gekennzeichnet, dass das infolge der Induktanz der Leitung und insbesondere der Stromquelle dem Spannungs-Eingangssignal nachlaufende Strom-Eingangssignal vorverschoben wird.

3. Verfahren nach Anspruch 2, dadurch gekennzeichnet, dass das Strom-Eingangssignal mittels einer Abbildung der Impedanz der Stromquelle in ein vorverschobenes Abbildspannungssignal gewandelt wird.

4. Vorrichtung zur Ausführung des Verfahrens gemäss dem Anspruch 1 mit zwei Eingangswandlern (41, 42 bzw. 70, 71) zum Erzeugen von Eingangssignalen, die einer sprunghaften Aenderung von Strom bzw. Spannung auf der zu überwachenden Leitung entsprechen und deren Signalausgang zur Bildung von Sprungsignalen mit einem zugeordneten Bandsperrfilter zum Ausfiltern (43, 44 bzw. 72, 73) der stationären, netzfrequenten Anteile aus den Eingangssignalen verbunden ist, sowie Schaltungen zum Vergleich der Vorzeichen der Sprungsignale, sowie zum Bilden eines Kombinationssignals aus den Sprungsignalen und Vergleich dieses Kombinationssignals mit vorgegebenen Grenzwerten, gekennzeichnet durch eine Einrichtung (48 bzw. 76 oder 65 bzw. 66) zum Ausgleichen der Phasenverschiebung mindestens des netzfrequenten Anteils der Eingangs- oder der Sprungsignale.

5. Vorrichtung gemäss dem Anspruch 4, dadurch gekennzeichnet, dass die Einrichtung 48, 76 ; 65, 66) zum Ausgleichen der Phasenverschiebung als Abbildschaltung ausgebildet ist, deren Impedanzwinkel praktisch dem Impedanzwinkel der Stromquelle entspricht.

6. Vorrichtung gemäss dem Anspruch 5, dadurch gekennzeichnet, dass die Einrichtung (48, 76) zum Ausgleich der Phasenverschiebung an die Verbindungsleitung zwischen dem Signalausgang des für das Strom-Eingangssignal vorgesehenen Eingangswandlers (42, 71) und dem Eingang des zugeordneten Bandsperrfilters (44, 73) angeschlossen ist.

7. Vorrichtung gemäss dem Anspruch 5, dadurch gekennzeichnet, dass die Einrichtung (65, 66) zum Ausgleich der Phasenverschiebung mit dem Ausgang des dem Strom-Sprungsignal zugeordneten Bandsperrfilters (44, 73) verbunden ist.

8. Vorrichtung gemäss dem Anspruch 5, dadurch gekennzeichnet, dass die Einrichtung zum Ausgleich der Phasenverschiebung einen als Streutransformator ausgebildeten Stromeingangswandler (42, 71) enthält und einen Widerstand (82), der der Sekundärwicklung des Streutransformators parallel geschaltet ist.

9. Vorrichtung gemäss dem Anspruch 4, dadurch gekennzeichnet, dass die Ausgänge der Bandsperrfilter (43, 44) mit den Eingängen eines zum Addieren und eines zum Subtrahieren der Sprungsignale vorgesehenen Rechenverstärkers (49 bzw. 51) verbunden sind und der Ausgang jedes Rechenverstärkers (49, 51) mit dem einen Eingang von zwei Komparatoren (52, 53 bzw. 54, 56) verbunden ist, deren anderer Eingang mit einem ein positives bzw. ein negatives Grenzwertsignal erzeugenden Signalgeneratoren (57, 58 und 59, 61) verbunden ist und mit einer Schaltlogik (62), deren Eingänge mit den Ausgängen der Komparatoren verbunden sind und die zwei Ausgänge (63, 64) aufweist, an denen in Abhängigkeit von den Eingangssignalen ein Fehlersignal erscheint (Fig. 3).

10. Vorrichtung gemäss dem Anspruch 4, dadurch gekennzeichnet, dass die Ausgänge der Bandsperrfilter (72, 73) mit Eingängen einer Zeitmultiplexschaltung (74) verbunden sind, deren Signalausgang über einen A/D-Wandler (77) an einen zum Bestimmen des Vorzeichens der Sprungsignale und zum Vergleich des Kombinationssignals mit dem vorgegebenen Grenzwerten programmierten Mikroprozessor (78) geführt ist (Fig. 4).

11. Vorrichtung zur Ausführung des Verfahrens gemäss dem Anspruch 1 mit zwei Eingangswandlern zum Erzeugen von Eingangssignalen, die einer sprunghaften Aenderung von Strom bzw. Spannung auf der zu überwachenden Leitung entsprechen, dadurch gekennzeichnet, dass die Signalausgänge der Eingangswandler (70, 71) mit den Eingängen einer Zeitmultiplexschaltung (74) verbunden sind, deren Signalausgang über einen A/D-Wandler (77) an einem zum Bilden der Sprungsignale, zum Bestimmen der Amplitude und des Vorzeichens dieser Sprungsignale und eines Kombinationssignales aus den Sprungsignalen, sowie zum Vergleich des Kombinationssignals mit den vorgegebenen Grenzwerten programmierten Mikroprozessor (78) geführt ist (Fig. 4).

**Claims**

1. Method for detecting any disturbance along a conductor in an interconnected system for distributing electric power, in which method step signals are formed from input signals coresponding to the step-like changes of current or voltage caused by a disturbance of load change and are combined to form a combined signal, which combined signal is compared with a predetermined limit value to differentiate between a disturbance and a permissable load change and for determining the direction of the disturbance relative to the location of detection, characterised in that the phase shift between the two step signals is virtually cancelled, before they are superimposed to form the combined signal, by displacing the variation with time of at least one of the input signals or at least one of the step signals itself, so that the variation with time of the combined signal virtually corresponds to a straight line in a rectangular system of coordinates, the axis of which are associated with the two step signals.

2. Method according to Claim 1, characterised in that the current input signal, which lags the voltage input signal due to the inductance of the line and particularly of the current source, is advanced.

3. Method according to Claim 2, characterised in that the current input signal is converted into an advanced image voltage signal by means of imaging the impedence of the current source.

4. Device for carrying out the method according to Claim 1, comprising two input transformers (41, 42 and 70, 71) for generating input signals which correspond to a step-like change of current and voltage on the line to be monitored and the signal output of which is connected to an associated band rejection filter (43, 44 and 72, 73) for filtering out the steady-state system-frequency components from the input signals for forming step-signals, and circuits for comparing the signs of the step signals and for forming a combined signal from the step signals and comparing this combined signal with the predetermined limit values, characterised by a device (48 and 76 or 65 and 66) for compensating the phase shift of a least the system-frequency component of the input signals or of the step signals.

5. Device according to Claim 4, characterised in that the device (48, 76 ; 65, 66) for compensating the phase shift is constructed as an image circuit, the impedence angle of which virtually corresponds to the impedence angle of the current source.

6. Device according to Claim 5, characterised in that the device (48, 76) for compensating the phase shift is connected to the connecting line between the signal output of the input transformer (42, 71) provided for the current input signal and the input of the associated band rejection filter (44, 73).

7. Device according to Claim 5, characterised in that the device (65, 66) for compensating the phase shift is connected to the output of the band rejection filter (44, 73) associated with the current step signal.

8. Device according to Claim 5, characterised in that the device for compensating the phase shift contains a current input transformer (42, 71) which is constructed as a leakage-reactance transformer, and a resistor (82) which is connected in parallel with the secondary winding of the leakage-reactance transformer.

9. Device according to Claim 4, characterised in that the outputs of the band rejection filter (43, 44) are connected to the inputs of an arithmetic amplifier (49) provided for adding and of an arithmetic amplifier (51) provided for subtracting the step signals and the output of each arithmetic amplifier (49, 51) is connected to one input of two comparitors (52, 53 and 54, 56) the other input of which is connected to a signal generator generating a positive limit-value signal and to a signal generator generating a negative limit-value signal (57, 58 and 59, 61) and to a switching logic (62) the inputs of which are connected to the outputs of the comparitors and which has two outputs (63, 64) at which an aerial signal appears as a function of the input signals (Figure 3).

10. Device according to Claim 4, characterised in that the outputs of the band rejection filter (72, 73) are connected to inputs of a time-division multiplex circuit (74) the signal output of which is carried via an A/D Converter (77) to a microprocessor (78) which is programmed for determining the sign of the step signals and for comparing the combined signal with the predetermined limit values (Figure 4).

11. Device for carrying out the method according to Claim 1, comprising two input transformers for generating input signals which correspond to a step-like change of current and voltage on the line to be monitored, characterised in that the signal outputs of the input transformers (70, 71) are connected to the inputs of a time-division multiplex circuit (74), the signal output of which is carried via an A/D Converter (77) to a microprocessor (78) which is programmed for forming the step-signals, for determining the amplitude and the sign of these step signals and of a combined signal of the step signals and for comparing the combined signal with the predetermined limit values (Figure 4).

**Revendications**

1. Procédé de détection d'un défaut le long d'un conducteur d'un réseau d'interconnexion pour distribuer de l'énergie électrique, selon lequel, à partir de signaux d'entrée qui correspondent aux variations en saut d'intensité ou de tension provoquées par un défaut ou une variation de charge, des signaux de saut sont formés et unis en un signal combiné qui, pour faire la distinction entre un défaut et une variation de charge tolérée ainsi que pour déterminer la direction du défaut par rapport à l'endroit de détection, est comparé à une valeur limite prédéfinie, caractérisé en ce que par déplacement de l'allure dans le temps d'au moins un des signaux d'entrée ou d'au moins un des signaux de saut lui-même, le déphasage entre les deux signaux de saut est pratiquement supprimé avant leur superposition en un signal combiné, de sorte que l'allure dans le temps du signal combiné correspond pratiquement à une ligne droite dans un système de coordonnées rectangulaires dont les axes sont associés aux deux signaux de saut.

2. Procédé suivant la revendication 1, caractérisé en ce que le signal d'entrée d'intensité qui, en raison de l'inductance du conducteur et en particulier de la source de courant, est en retard par rapport au signal d'entrée de tension, est prédécalé.

3. Procédé suivant la revendication 2, caractérisé en ce que le signal d'entrée d'intensité est converti au moyen d'une image de l'impédance de la source de courant, en un signal de tension d'image prédécalé.

4. Appareil pour l'exécution du procédé suivant la revendication 1 comportant deux transformateurs d'entrée (41, 42 et 70, 71) pour produire des signaux d'entrée qui correspondent à une variation en saut de l'intensité ou de la tension sur le conducteur à surveiller et dont la sortie de signal, en vue de former des signaux de saut, est connectée à un filtre éliminateur de bande associé pour filtrer (43, 44 ou 72, 73) les parties stationnaires à la fréquence du réseau des signaux d'entrée, ainsi que des circuits pour comparer le signe des signaux de saut et pour former un signal combiné à partir des signaux de saut et comparer ce signal combiné à des valeurs limites prédéfinies, caractérisé par un dispositif (48/76 ou 65/66) pour compenser le déphasage au moins de la fraction de signaux d'entrée ou de saut à la fréquence du réseau.

5. Appareil suivant la revendication 4, caractérisé en ce que le dispositif (48, 76 ; 65, 66) destiné à compenser le déphasage a la forme d'un circuit d'image dont l'angle d'impédance correspond pratiquement à l'angle d'impédance de la source de courant.

6. Appareil suivant la revendication 5, caractérisé en ce que le dispositif (48, 76) destiné à compenser le déphasage est connecté à la ligne de connexion entre la sortie de signal du transformateur d'entrée (42, 71) prévu pour le signal d'entrée d'intensité et l'entrée du filtre éliminateur de bande (44, 73) associé.

7. Appareil suivant la revendication 5, caractérisé en ce que le dispositif (65, 66) destiné à compenser le déphasage est connecté à la sortie du filtre éliminateur de bande (44, 73) associé au signal de saut d'intensité.

8. Appareil suivant la revendication 5, caractérisé en ce que le dispositif destiné à compenser le déphasage comprend un transformateur d'entrée d'intensité (42, 71) ayant la forme d'un transformateur à dispersion et une résistance (82) qui est connectée en parallèle au secondaire du transformateur à dispersion.

9. Appareil suivant la revendication 4, caractérisé en ce que les sorties des filtres éliminateurs de bande (43, 44) sont connectées aux entrées de deux amplificateurs de calcul (49 et 51) dont l'un est prévu pour additionner et l'autre pour soustraire les signaux de saut et la sortie de chaque amplificateur de calcul (49, 51) est connectée à la première entrée de deux comparateurs (52, 53 et 54, 56) dont d'autre entrée est connectée chaque fois à un générateur de signaux (57, 58 et 59, 61) produisant un signal à valeur de seuil positif et un signal à valeur de seuil négatif et à un circuit logique (62) dont les entrées sont connectées aux sorties des comparateurs et qui comporte deux sorties (63, 64) auxquelles un signal d'erreur apparaît en fonction des signaux d'entrée (Fig. 3).

10. Appareil suivant la revendication 4, caractérisé en ce que les sorties des filtres éliminateurs de bande (72, 73) sont connectées aux entrées d'un circuit de multiplexage dans le temps (74) dont la sortie de signaux est connectée par l'intermédiaire d'un convertisseur analogique/numérique (77) à un microprocesseur (78) programmé pour déterminer le signe des signaux de saut et pour comparer le signal combiné aux valeurs limites prédéfinies (Fig. 4).

11. Appareil pour réaliser le procédé suivant la revendication 1 comportant deux transformateurs d'entrée destinés à produire des signaux d'entrée qui correspondent à une variation en saut d'intensité ou de tension sur le conducteur à surveiller, caractérisé en ce que les sorties de signaux des transformateurs d'entrée (70, 71) sont connectées aux entrées d'un circuit de multiplexage dans le temps (74) dont la sortie de signaux est connectée par l'intermédiaire d'un convertisseur analogique/numérique (77) à un microprocesseur (78) programmé pour former les signaux de saut, pour déterminer l'amplitude et le signe de ces signaux de saut et former un signal combiné à partir des signaux de saut, ainsi que pour comparer le signal combiné aux valeurs limites prédéfinies (Fig. 4).

0 084 191

Fig.1

Fig. 2

1

Fig. 3

Fig. 4